# EUROPÄISCHE PATENTSCHRIFT

(11) **EP 0 916 237 B1**
(45) Veröffentlichungstag und Bekanntmachung des Hinweises auf die Patenterteilung: **17.01.2001**
(21) Anmeldenummer: 97929082.2
(22) Anmeldetag: 17.07.1997
(51) Int. Cl.: H05K 3/00, H05K 1/02, H05K 9/00

(54) **VERFAHREN ZUR HERSTELLUNG VON VERBINDUNGSLEITERN**
PROCESS FOR PRODUCING CONNECTING CONDUCTORS
PROCEDE DE PRODUCTION DE CONDUCTEURS DE CONNEXION

(30) Priorität: 31.07.1996 CH 190396
(43) Veröffentlichungstag der Anmeldung: 19.05.1999
(73) Patentinhaber: Dyconex Patente, 6300 Zug (CH)
(72) Erfinder: SCHMIDT, Walter, CH-8050 Zürich (CH); MARTINELLI, Marco, CH-8413 Neftenbach (CH)
(74) Vertreter: Frei, Alexandra Sarah
(86) Internationale Anmeldenummer: CH9700277
(87) Internationale Veröffentlichungsnummer: WO9806243

(56) Entgegenhaltungen:
- EP-A- 0 337 331
- EP-A- 0 668 712
- WO-A-93/26143
- DE-U- 8 800 612
- GB-A- 2 277 832
- PATENT ABSTRACTS OF JAPAN vol. 14, no. 533 (E-1005), 22.November 1990 & JP 02 224398 A (HITACHI CHEM CO), 6.September 1990,
- 28448: "Reducing crosstalk in coplanar PC signal lines" RESEARCH DISCLOSURE, Nr. 284, Dezember 1987, HAVANT GB, Seite 785 XP002024706

## Beschreibung

Die Erfindung bezieht sich auf die Herstellung von Verbindungsleitern und betrifft ein Verfahren zur Herstellung von abgeschirmten Verbindungsleitern aus Folienhalbzeugen wie sie in den Patentansprüchen definiert sind.

Die moderne Elektronik entwickelt sich rasant und verlangt nach immer kostengünstigeren und immer kompakteren Komponenten. Als Beispiel seien die Leiterplatten erwähnt, welche immer höhere Verbindungsdichten aufweisen und die immer mehr elektronische Bauelemente wie Surface Mounted Devices (SMD) oder Leadless Ceramic Chip Carriers (LCCC) tragen und verbinden. Hierbei seien insbesondere die Substrate zur Herstellung von Multichip-Modulen (MCM) genannt, welche zunehmend ungehäuste Bausteine (nackte Si-Chips) tragen und verbinden.

Eine solche Erhöhung der Verbindungsdichte von Leiterplatten wird gemäss dem DYCOstrate®-Verfahren realisiert und ist beispielsweise in der Schrift **WO93/26'143** der Anmelderin offenbart. Dabei werden dünne Kunststoffolien zur elektrischen Durchverbindung in Z-Richtung und zur Bildung von elektrischen Durchkontaktierungslöcher mittels Plasma bzw. chemisch geätzt. Dieses Verfahren gestattet eine simultane, sehr kostengünstige Herstellung von kleinsten Löchern beliebiger Form. Neben einer massiven Erhöhung der erzielbaren Verbindungsdichte weist das DYCOstrate®-Verfahren noch eine Reihe weiterer Vorteile auf, die in der genannten Schrift beschrieben sind.

Die hohe Verbindungsdichte bei ungleichmässigem Leiterabstand heutiger Leiterplatten führt bei hochfrequenten Anwendungen (Frequenzen >1GHz) zu Störungen, wie übermässige Dämpfungen, unerwünschte Reflexionen oder zum Übersprechen von Signalen. Aus diesem Grund müssen die Verbindungsleiter der Leiterplatten beispielsweise einen möglichst gleichmässigen Abstand zueinander aufweisen oder besser noch, sie müssen als teilweise oder vollabgeschirmte Verbindungsleiter realisiert werden.

Die Schrift **GB-2,277,832** wird als nächster Stand der Technik angesehen. Diese Schrift zeigt ein Verfahren zur Herstellung von abgeschirmten Verbindungsleitern aus Folienhalbzeugen auf. Hierbei wird eine Lage Signalleiter über Isolationsmaterial mit einer Lage Abschirmungsmaterial verbunden. Die Signalleiter sind ganz von Isolationsmaterial umgeben. Einseitig werden im Isolationsmaterial Kanäle freigelegt, die seitlich neben Signalleitern verlaufen und die bis auf das Abschirmungsmaterial reichen. Daraufhin werden einseitig das Isolationsmaterial und das Abschirmungsmaterial am Boden der Kanäle mit weiterem Abschirmungsmaterial bedeckt, so dass die Signalleiter ganz von Abschirmungsmaterial umgeben sind.

Die vorliegende Erfindung hat zur Aufgabe, ein Verfahren aufzuzeigen, mit dem eine einfache und kostengünstige Herstellung abgeschirmter Verbindungsleitern aus ätzbaren Folienhalbzeugen mit extrem dünnen und extrem feinen Leiterstrukturen möglich ist. Es sollen dabei bekannte und bewährte Techniken, Materialien und dergleichen zur Anwendung kommen, beispielsweise sollen zur Herstellung der Leiterstrukturen bekannte nasschemische Verfahren anwendbar sein. Diese Verbindungsleiter sollen in bezug auf die Weiterverarbeitung, insbesondere bezüglich der Bestückung und der Anwendung mit bekannten Systemen wie dem DYCOstrate®-Verfahren kompatibel sein. Ferner soll die Herstellung von Verbindungsleitern unter Verwendung solcher Folienhalbzeuge automatisch, beispielsweise von Rollezu-Rolle ablaufbar sein, wobei auch ein zuführender Chargenbetrieb durch Einschleusung von beispielsweise Trägerplatten möglich sein soll.

Diese Aufgabe wird durch die Erfindung gemäss der Patentansprüche gelöst.

Es hat sich überraschenderweise herausgestellt, dass sich im DYCOstrate®-Verfahren nicht nur punktartig angeordnete elektrische Durchverbindungen in z-Richtung (Durchganslöcher) sondern dass sich auch flächige Durchverbindungen in z-Richtung (Öffnungen in Form von Nuten oder Rillen) präzise herstellen lassen. Erfindungsgemäss wird dies ausgenutzt, um Signalleiter in einer bestimmten Lage eines Folienhalbzeugs durch Herstellung von flächigen Durchverbindungen von Abschirmungsmaterial aus anderen Lagen abzuschirmen. Diese Durchverbindungen von Abschirmungsmaterial erfolgen in einer Art Umwickeln des durch Dielektrikum isolierten Signalleiters mit Abschirmungsmaterial. Dieses Umwickeln kann durch Aufplattieren (galvanisches Abscheiden) von weiterem Abschirmungsmaterial, oder es kann durch Siebdruck, Dispender-Auftrag, manuelles Auftragen von weiterem Abschirmungsmaterial geschehen. Auf diese Weise lassen sich eine oder mehrere Lagen Signalleiter teilweise oder vollständig abgeschirmen. Diese Herstellung abgeschirmter Verbindungsleiter aus beispielsweise ätzbaren Folienhalbzeugen mit extrem dünnen und extrem feinen Leiterstrukturen ist mit gängigen Techniken der Leiterplatten-Industrie und mit dem DYCOstrate®-Verfahren kompatibel.

Ein erstes Folienhalbzeug mit mindestens einer Lage Leiter bestehend aus Signalleitern und Abschirmungsleitern wird mit mindestens einem weiteren Folienhalbzeug mit Abschirmungsmaterial verbunden. Vorteilhafterweise wird das Abschirmungsmaterial über Dielektrikum mit mindestens einer Lage Leiter auflaminiert. In einer photochemischen Strukturierung wird das Abschirmungsmaterial daraufhin mit bis auf das Dielektrikum reichenden Öffnungen versehen. In einem chemischen oder einem Plasma-Ätz-Prozesses oder auch durch Laser-Ablation wird das Dielektrikum gemäss diesen Öffnungen bis auf Abschirmungsleiter abgetragen. Die Ränder der Öffnungen im Abschirmungsmaterial werden mit diesen Abschirmungsleitern elektrisch kontaktiert, sodass durch Dielektrikum isolierte Signalleiter und von Abschirmungsleitern und Abschirmungsmaterial abgeschirmt werden.

Die folgenden Zeichnungen erläutern die Erfindung näher.
- **Figur 1 bis 5**: zeigen eine erste beispielhafte Verfahrensvariante der Herstellung abgeschirmter Verbindungsleiter 1 aus drei Folienhalbzeugen H1,H2,H3 (Variante mit einlagigem Folienhalbzeug H1).
- **Figur 6 und 7**: zeigen eine weitere beispielhafte Verfahrensvariante der Herstellung abgeschirmter Verbindungsleiter 1 aus drei Folienhalbzeugen H1,H2,H3 (Variante mit zweilagigem Folienhalbzeug H1).
- **Figur 8 und 9**: zeigen eine weitere beispielhafte Verfahrensvariante der Herstellung abgeschirmter Verbindungsleiter 1 aus drei Folienhalbzeugen H1,H2,H3 (Variante mit zweilagigem, durchkontaktierten Folienhalbzeug H1).
- **Figur 10 und 11**: zeigen eine weitere beispielhafte Verfahrensvariante der Herstellung abgeschirmter Verbindungsleiter 1 aus zwei Folienhalbzeugen H1,H2 (Variante mit zweilagigem Folienhalbzeug H1).

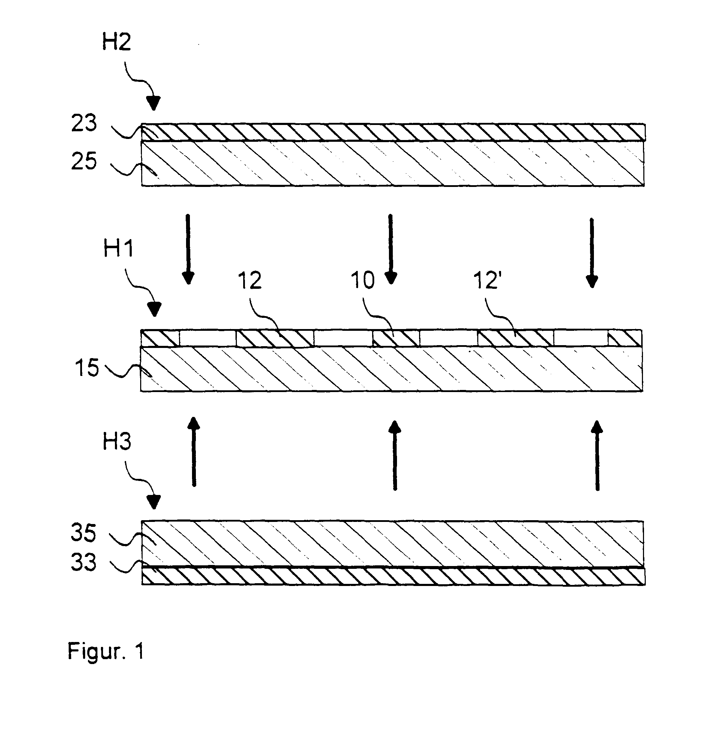

Die **Figuren 1 bis 5** zeigen eine erste beispielhafte Verfahrensvariante der Herstellung abgeschirmter Verbindungsleiter **1** aus drei Folienhalbzeugen **H1,H2,H3** (Variante mit einlagigem Folienhalbzeug **H1**). Diese Figuren (wie auch die folgenden) sind schematisch und sollen weniger die exakten Dicken der Lagen sowie exakte Abstände angeben, als dass sie die Abfolge der erfindungsgemässen Verfahrensschritte veranschaulichen.

Die verwendeten Folienhalbzeuge **H1,H2,H3** weisen Lagen dielektrischen oder isolierenden Materials **15,25,35** sowie Lagen elektrisch leitfähigen Materials oder Lagen Leiter **10,12,12'** bzw. Abschirmungsmaterial **23,33** auf.

Das erste Folienhalbzeug **H1** besteht beispielsweise aus einer 50 µm dicken Polyimidfolie als Dielektrikum **15**, die einseitig mit einer beispielsweise 18 µm dicken Kupferfolie (diese Dicke ist augenblicklich ein Standard) auflaminiert ist. Diese gemäss **Figur 1** einseitig aufgebrachte Leitfolie ist vorteilhafterweise mit darin feinen Leitern **10,12',12'** strukturiert. Die Verwendung einer Lage Dielektrikum **15** ist fakultativ, sie dient als mechanischer Träger von Signalleitern **10** und von Abschirmungsleitern **12,12'**. Die Signalleiter **10** sowie die Abschirmungsleiter **12,12'** sind typischerweise 10 bis 100 µm breit und verlaufen vorteilhafterweise parallel zueinander. Natürlich ist es dem Fachmann bei Kenntnis der vorliegenden Erfindung möglich, auch schmalere bzw. breitere Signalleiter und Abschirmungsleiter anzulegen, die auch, zumindestens bereichsweise, schräg zueinander verlaufen.

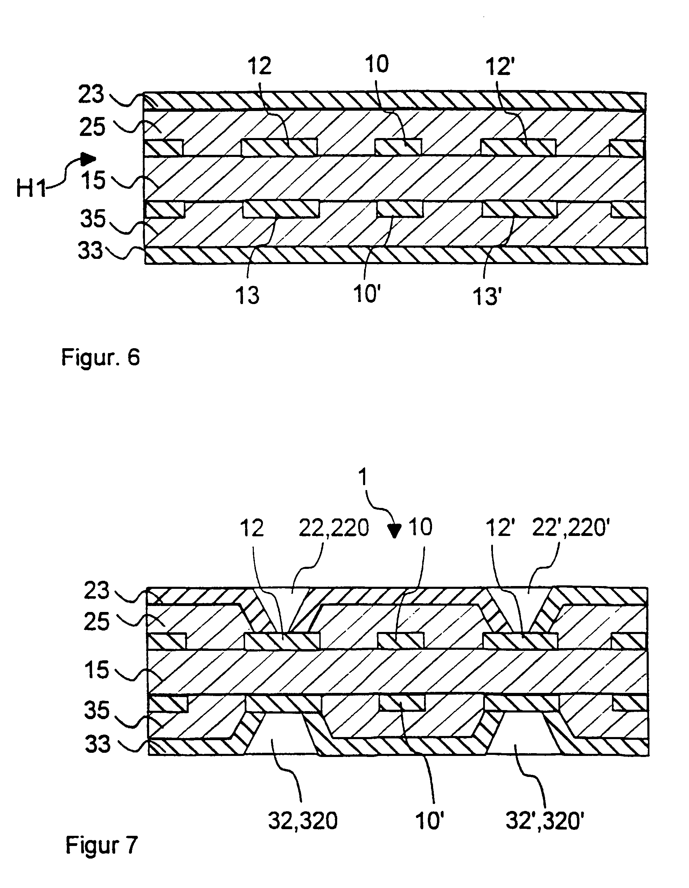

Die weiteren Folienhalbzeuge **H2,H3** bestehen beispielsweise aus dielektrischen Klebefolien **25,35**, die einseitig mit einer beispielsweise 18 µm dicken Kupferfolie (diese Dicke ist augenblicklich ein Standard) als Lage Abschirmungsmaterial **23,33** auflaminiert sind. Vorteilhafterweise ist diese Lage Abschirmungsmaterial **23,33** nicht strukturiert und flächig zusammenhängend. Diese verbindenden Dielektrika **25,35** bestehen beispielsweise aus 25 bis 100 µm dicken Polyimid-, Acrylat-, Epoxyd- bzw. Epoxyd-Acrylat-Verbindungen. Sie ermöglichen ein einfaches, preiswertes und bewährtes Verbinden der Folienhalbzeuge **H1,H2,H3**. Ein solches Verbinden erfolgt vorteilhafterweise durch Auflaminieren unter Druck und Temperatur (gekennzeichnet durch die Druckpfeile in **Figur 1**). In weiteren, später beschriebenen Verfahrensvarianten, wird die Verwendung eines mehrlagigen ersten Folienhalbzeugs **H1**, sowie die Verwendung von nur einem weiteren Folienhalbzeug **H2** beschrieben. Bei Kenntnis der vorliegenden Erfindung lassen sich natürlich auch andere gebräuchlichen Metalle und Legierungen als Leiter **10,12,12'** bzw. Abschirmungsmaterial **23,33** verwenden, hierbei sei insbesondere die Verwendung von Metallschichten aus Aluminium, aus verzinntem Kupfer, aus Nickel-Goldbeschichtem Kupfer, usw. erwähnt. Des weiteren kann der Fachmann bei Kenntnis der Erfindung auch dickere bzw. dünnere Lagen Dielektrikum **15,25,35** und Leiter **10,12,12'** bzw. Abschirmungsmaterial **23,33** verwenden-Natürlich ist es möglich, auch andere, beispielsweise nicht folienartige Dielektrikamaterialien, oder beispielsweise nicht plasma-ätzbare Dielektrikamaterialien, oder beispielsweise nicht chemisch ätzbare Dielektrikamaterialien, oder auch beispielsweise nicht oder schwer mit Laser abtragbare Dielektrikamaterialien zu verwenden. Insbesondere können Lagen aus solchen anderen Dielektrika relativ starr sein, oder sie können wenig flexibel (unbiegbar) sein, oder sie können auch nicht aufrollbar sein. Als Beispiel sei die Verwendung von glasfaserverstärkten Harzverbindungen wie FR4, FR5, etc. erwähnt. Solche glasfaserverstärkten Harzverbindungen sind beispielsweise nicht plasmaätzbar, oder sie sind beispielsweise nicht chemisch ätzbar, oder sie sind beispielsweise nicht oder schwer mit Laser abtragbar. Solche anderen Halbzeuge können in Halbzeugen dort verwendet werden, wo keine Strukturierung im Plasma-Ätz-Prozess, oder in einem chemischen Prozess, oder durch Laser-Ablation stattfindet bzw. nicht unbedingt nötig ist, also beispielsweise als anderes Dielektrika **15** der Halbzeuge **H1** in den Verfahrensvarianten gemäss der **Figuren 6 bis 11**. Der Vorteil von solchen glasfaserverstärkten Harzverbindungen ist der, dass sie einfach zu verarbeiten und dass sie preislich günstiger als beispielsweise Polyimidfolien sind. Solche anderen Dielektrika können ein - oder beidseitig mit Metallschichten versehen sein. Sie können auch Teil weiterer Komponenten sein und ganz verschiedene Funktionen erfüllen, beispielsweise können sie Teil eines Kerns einer klassischen, d.h. starren Leiterplatte mit gebohrten Durchgangslöchern, usw. sein.

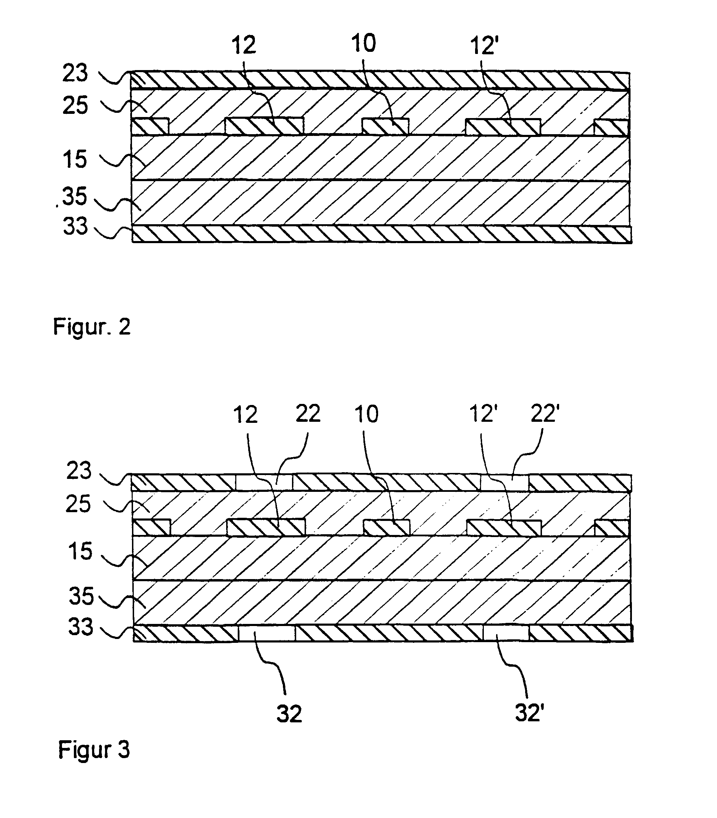

Die **Figuren 1 und 2** zeigen wie ein erstes Folienhalbzeug **H1** mit mindestens einer Lage Leiter **10,12,12'** bestehend aus Signalleitern **10** und Abschirmungsleitern **12,12'** mit mindestens einem weiteren Folienhalbzeug **H1,H2** mit Abschirmungsmaterial **23,33** verbunden wird. Vorteilhafterweise wird das Abschirmungsmaterial **23,33** über verbindendes Dielektrikum **25,35** des mindestens einen Folienhalbzeugs **H2,H3** mit der mindestens einen Lage Leiter **10,12,12'** des Folienhalbzeugs **H1** auflaminiert. Andere in der Leiterplatten-Industire gängige Verbindungstechniken sind natürlich auch anwendbar.

In einer photochemischen Strukturierung gemäss **Figur 3** wird das Abschirmungsmaterial **23,33** mit bis auf das darunterliegende Dielektrikum **15,25,35** reichenden Öffnungen **22,22',32,32'** versehen. Vorteilhafterweise werden diese Öffnungen **22,22',32,32'** im Abschirmungsmaterial **23,33** im Bereich, d.h. ober- bzw. unterhalb von Abschirmungsleitern **12,12'** angelegt. Diese Öffnungen **22,22',32,32'** im Abschirmungsmaterial **23,33** folgen quasi dem Verlauf der Abschirmungsleiter **12,12'**, sodass diese Öffnungen **22,22',32,32'** Nuten oder Rillen im bis dahin zusammenhängenden Abschirmungsmaterial **23,33** darstellen.

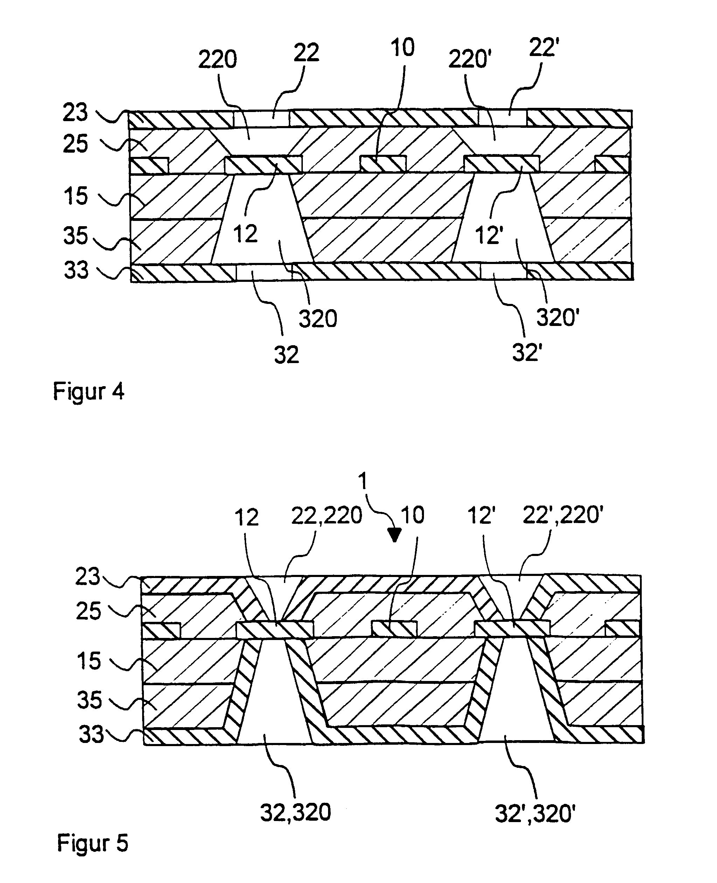

Durch diese Nuten oder Rillen im Abschirmungsmaterial 23,33 wird flächig Dielektrikum **15,25,35** freigelegt. Dieses derart freigelegte Dielektrikum **15,25,35** wird daraufhin gemäss diesen Öffnungen **22,22',32,32'** bis auf die Abschirmungsleiter **12,12'** abgetragen. Dieses Abtragen von Dielektrikum **15,25,35** kann auf vielfältige Art und Weise geschehen. Bekannt ist das Abtragen durch chemische oder auch Plasma-Ätz-Prozesse, bei denen das Dielektrikum **15,25,35** durchgeätzt wird. Es liegt aber durchaus im Rahmen der vorliegenden Erfindung, ein solches Abtragen durch andere gängige Techniken der Leiterplatten-Industrie wie beispielsweise Laser-Ablation durchzuführen. Dem Fachmann stehen bei Kenntnis der vorliegenden Erfindung somit vielfältige Möglichkeiten der Variation des erfindungsgemässen Verfahrens offen. **Figur 4** zeigt die freigelegten Abschirmungsleiter **12,12'**. Die Ränder dieser Öffnungen **22,22',32,32'** werden dabei, beispielsweise in einem Plasma-Ätz-Vorgang, hinterätzt und stehen über die Dielektrikumsöffnungen **220,220',320,320'**. Die Wände dieser Dielektrikumsöffnungen **220,220',320,320'** sind beispielsweise schräg.

**Figur 5** zeigt wie die Ränder dieser Öffnungen **22,22',32,32'** im Abschirmungsmaterial **23,33** mit den freigelegten Abschirmungsleiter **12,12'** elektrisch und mechanisch dauerhaft kontaktiert werden- Auch hier hat dem Fachmann bei Kenntnis der vorliegenden Erfindung vielfältige Möglichkeiten der Ausbildung von elektrischen und mechanisch dauerhaften Kontaktierungen zwischen Abschirmungsmaterial und Abschirmungsleitern. Diese Kontaktierung erfolgt vorteilhafterweise in einem Aufplattierungs-Vorgang (beispielsweise durch galvanisches Abscheiden von Kupfer). Es ist aber durchaus möglich, elektrisch leitfähiges Material wie beispielsweise leitfähige Polymere (leitfähige Pasten oder Lacke mit Silber, Kupfer, Gold, Aluminium, Russ, etc.) in die Öffnungen **22,22',32,32'** im Abschirmungsmaterial **23,33** und in die Dielektrikumsöffnungen **220,220',320,320'** einzubringen. Dieses Einbringen von leitfähigem Material kann im Siebdruck, als Dispenser-Auftrag oder auch auf andere Art und Weise, manuell, etc. geschehen- Optional, können die überstehenden Ränder um Öffnungen **22,22',32,32'** entweder in Richtung der Abschirmungsleiter **12,12'** umgebogen und auf rein mechanischem Weg elektrisch kontaktiert werden, oder sie können, wie beispielsweise in der Anmeldung **EP-0'668'712** der Anmelderin offenbart, selektiv abgeätzt werden.

Diese erste Ausführungsform eines Verbindungsleiters **1** gemäss **Figur 5** kennzeichnet sich durch einen einzigen Signalleiter **10**, der in einer einzigen Lage Leiter exzentrisch zum Abschirmungsmaterial **23,33** verläuft. Dieser Signalleiter **10** ist durch Dielektrikum **15,25,35** isoliert und er ist durch Abschirmungsleiter **12,12'** und durch Abschirmungsmaterial **23,33** vollständig abgeschirmt. Die weiteren Ausführungsformen von erfindungsgemäss hergestellten Verbindungsleitern **1** stellen Varianten hierzu dar. Es ist wichtig festzuhalten, dass durch die fein strukturierten Abschirmungsleitern **12,12'** weitgehend parallel und beabstandet in der Lage des abzuschirmenden fein strukturierten Signalleiters **10** verlaufen, dass die Lagen verbindendes Dielektrikum **25,35** sowie tragendes Dielektrikum **15** weitgehend konstant sind, dass das Wegätzen von Dielektrikum **15,25,35** bevorzugt kontrolliert oberhalb der Abschirmungsleitern **12,12'** erfolgt, sodass ein Beibehalten der gewählten Dielektrikumsdicken im gesamten Bereich der herzustellenden Folienleiterplatte speziell für Hochfrequenzanwendungen (Frequenzen >1 GHz) gewährleistet ist. Die Abschirmungsleiter **12,12'** folgen somit dem abzuschirmenden Signalleiter **10**, ähnlich wie ein Damm einem Flussverlauf folgt.

Die **Figuren 6 und 7** zeigen eine weitere beispielhafte Verfahrensvariante der Herstellung von abgeschirmten Verbindungsleitern **1** aus drei Folienhalbzeugen **H1,H2,H3** (Variante mit zweilagigem Folienhalbzeug **H1**). Diese Variante ähnelt weitgehend derjenigen gemäss der **Figuren 1 bis 5**, der einzige Unterschied besteht in der Verwendung eines beidseitig mit Leitern **10,10',12,12',13,13'** versehenen ersten Folienhalbzeugs **H1**, sodass lediglich die laminierten Folienhalbzeuge gemäss **Figur 6** (analog zu **Figur 2**) und die weitere Ausführungsform eines Verbindungsleiters **1** gemäss **Figur 7** (analog zu **Figur 5**) abgebildet sind. Die Ausführungsform eines Verbindungsleiter 1 gemäss **Figur 7** weist zwei parallel zueinander verlaufende Signalleiter **10,10'** auf, von denen der eine in einer Lage Leiter **10,12,13** und der andere in einer anderen Lage Leiter **10',12',13'** verläuft, welche Lagen durch Dielektrikum **15** voneinander getrennt sind. diese Signalleiter **10,10'** verlaufen exzentrisch zum Abschirmungsmaterial **23,33**.

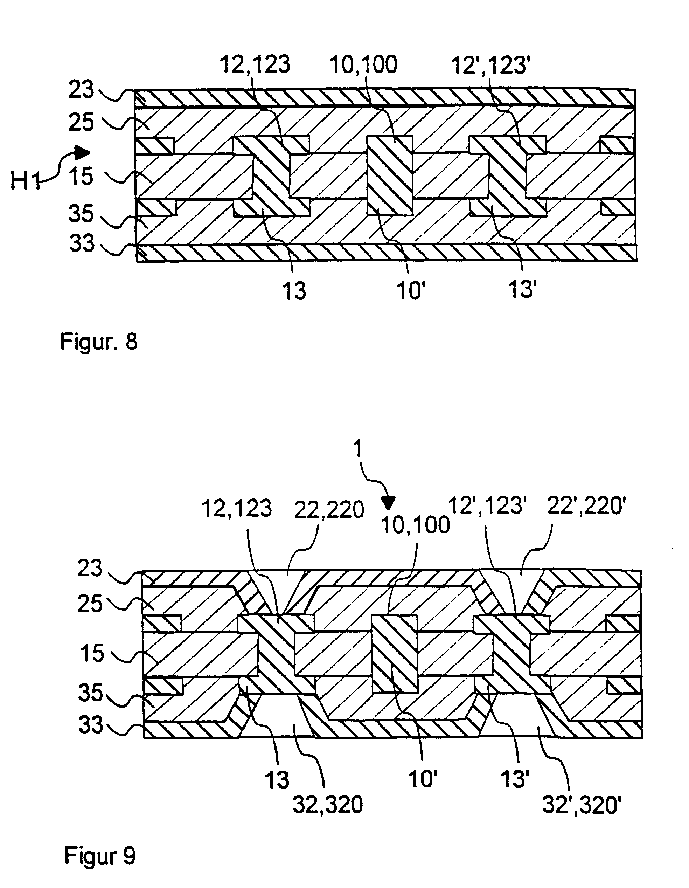

Die **Figuren 8 und 9** zeigen eine weitere beispielhafte Verfahrensvariante der Herstellung von abgeschirmten Verbindungsleitern **1** aus drei Folienhalbzeugen **H1,H2,H3** (Variante mit zweilagigem, durchkontaktierten Folienhalbzeug **H1**). Auch diese Variante ähnelt weitgehend denjenigen gemäss der **Figuren 1 bis 7**. Der Unterschied besteht in der Verwendung eines beidseitig mit Leitern **10,10',12,12',13,13'** versehenen ersten Folienhalbzeugs **H1**, welche Leitern **10,10',12,12',13,13'** in nicht abgebildeten Verfahrensschritten, beispielsweise gemäss dem DYCOstrate®-Verfahren, vorgängig zu durchkontaktierten Leitern **100,123,123'** verbunden werden. Die Signalleiter **10,10'** aus zwei durch ein Dielektrikum **15** getrennten Lagen sind zu einem durchkontaktierten Signalleiter **100** verbunden, die Abschirmungsleiter **12,12'** der einen Lage und die Abschirmungsleiter **13,13'** der von dieser durch ein Dielektrikum **15** getrennten weiteren Lage, sind zu durchkontaktierten Abschirmungsleitern **123,123'** verbunden. Wiederum sind lediglich die laminierten Folienhalbzeuge gemäss **Figur 8** (analog zu den **Figuren 2 und 6**) und die weitere Ausführungsform eines Verbindungsleiters **1** gemäss **Figur 9** (analog zu den **Figuren 5 und 7**) abgebildet. Die Ausführungsform eines Verbindungsleiter **1** gemäss **Figur 9** kennzeichnet sich durch einen Signalleiter **100**, der in zwei Lagen Leiter konzentrisch zum Abschirmungsmaterial **23,33** verläuft.

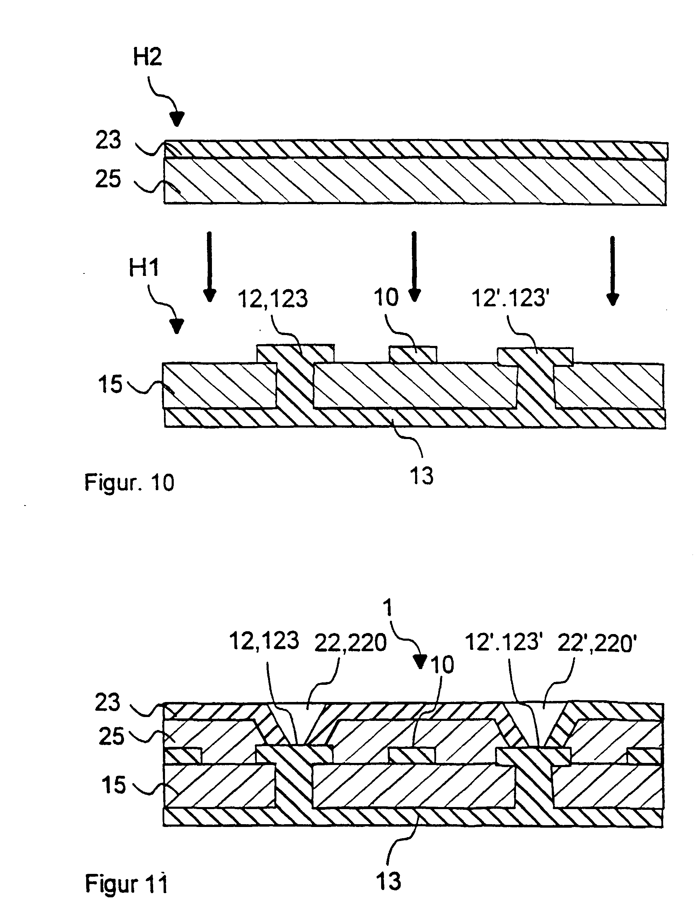

Die **Figuren 10 und 11** zeigen eine weitere beispielhafte Verfahrensvariante der Herstellung von abgeschirmten Verbindungsleitern **1** aus zwei Folienhalbzeugen **H1,H2** (Variante mit zweilagigem Folienhalbzeug **H1**). Diese Variante ähnelt weitgehend derjenigen gemäss der **Figuren 8 und 9**. Der erste Unterschied besteht in der Verwendung eines einzigen nicht durchkontaktierten Signalleiters **10** in einem mit zwei Lagen Leitern **10,12,12',13** versehenen ersten Folienhalbzeugs **H1**. Diese Lagen Leiter **12,12',13** sind durch ein Dielektrikum **15** voneinander getrennt. Die Abschirmungsleiter **12,12',13** sind in nicht abgebildeten vorgängigen Verfahrensschritten, beispielsweise gemäss dem DYCOstrate®-Verfäbren, zu durchkontaktierten Abschirmungsleitern **123,123'** miteinander verbunden. Der weitere Unterschied besteht darin, dass lediglich ein weiteres Folienhalbzeug **H2** und somit nur eine Lage Abschirmungsmaterial **23** mit dem Folienhalbzeug **H1** verbunden wird (siehe **Figur 10**). **Figur 11** zeigt (analog zu **Figur 9**) die entstehende weitere Ausführungsfornl eines Verbindungsleiters **1**. Dieser Verbindungsleiter **1** gemäss **Figur 11** weist einen Signalleiter **10** auf, der exzentrisch zum Abschirmungsmaterial **23** und den durchkontaktierten Abschirmungsleitern **123,123'** verläuft.

Natürlich lassen sich die gezeigten Verfahrensvarianten, bei Kenntnis der vorliegenden Erfindung, weiter kombinieren, was für das Verständnis des erfindungsgemässen Verfahrens aber nichts weiter bringt, weshalb solche Varianten einzig aus Platz- und Kostengründen nicht anhand weiterer Figuren gezeigt werden.

So ist die Ausführungsform von Verbindungsleitern **1** herstellbar nach der Verfahrensvariante gemäss den **Figuren 6 und 7** nicht auf parallel zueinander verlaufende Signalleiter **10,10'** (gemäss **Figur 7**) eingeschränkt, es ist durchaus möglich, dass dieselben Signalleiter **10,10'** in anderen Bereichen schräg zueinander (sich beispielsweise kreuzend) verlaufen.

So sind die Ausführungsformen von Verbindungsleitern **1** herstellbar nach den Verfahrensvarianten gemäss der **Figuren 1 bis 11** nicht auf erste Folienhalbzeuge **H1**, bestehend aus lediglich einer Lage Dielektrikum **15** mit ein oder zwei Lagen Leiter **10,10',12,12',13,13'** beschränkt, sondern es lassen sich natürlich auch höherlagige erste Folienhalbzeuge mit mehr als einer Lage Dielektrikum und mit mehr als zwei gegeneinander isolierte und/oder durchkontaktierter Lagen Leiter verwenden.

## Patentansprüche

1. Verfahren zur Herstellung von abgeschirmten Verbindungsleitern **(1)** aus Folienhalbzeugen **(H1,H2,H3),**
**wobei,**
ein erstes Folienhalbzeug (**H1**) mit mindestens einer Lage Leiter **(10,10',12,12',13,13')** verwendet wird, welche Leiter **(10,10',12,12',13,13')** aus Signalleitern **(10,10')** und aus Abschirmungsleitem **(12,12',13,13')** bestehen,
mindestens ein weiteres Folienhalbzeug **(H2,H3)** mit Abschirmungsmaterial **(23,33)** verwendet wird,
das Abschirmungsmaterial **(23,33)** über Dielektrikum **(15,25,35)** mit der mindestens einen Lage Leiter **(10,10',12,12',13,13')** verbunden wird,
das Abschirmungsmaterial **(23,33)** in einer photochemischen Strukturierung im Bereich der Abschirmungsleiter **(12,12',13,13')** mit auf Dielektrikum **(15,25,35)** reichenden Öffnungen **(22,22',32,32')** versehen wird,
das Dielektrikum **(15,25,35)** gemäss der Öffnungen **(22,22', 32,32')** im Abschirmungsmaterial **(23,33)** bis auf Abschirmungsleiter **(12,12',13,13')** abgetragen wird und
das Abschirmungsmaterial **(23,33)** über Öffnungen **(22,22', 32,32')** im Abschirmungsmaterial **(23,33)** mit Abschirmungsleitem **(12,12',13,13')** elektrisch kontaktiert wird,
sodass durch Dielektrikum **(15,25,35)** isolierte Signalleiter **(10,10')** und von Abschirmungsleitem **(12,12',13,13')** und von davon elektrisch verbundenem Abschirmungsmaterial **(23,33)** abgeschirmt sind.

2. Verfahren gemäss Anspruch 1, **dadurch gekennzeichnet**, dass das erste Folienhalbzeug (**H1)** mit der Lage Leiter **(10,12,12')** auf einem ersten Dielektrikum **(15)** verwendet wird, dass ein weiteres Folienhalbzeug **(H2)** mit Abschirmungsmaterial **(23)** über weiteres Dielektrikum **(25)** mit der Lage Leiter **(10,12,12')** verbunden wird und dass ein weiteres Folienhalbzeug **(H3)** mit Abschirmungsmaterial **(33)** über weiteres Dielektrikum **(35)** mit dem ersten Dielektrikum **(15)** verbunden wird.

3. Verfahren gemäss Anspruch 1, **dadurch gekennzeichnet**, dass das erste Folienhalbzeug **(H1)** mit zwei Lagen Leiter **(10,10',12,12',13,13')** auf einem ersten Dielektrikum **(15)** verwendet wird, dass ein weiteres Folienhalbzeug **(H2)** mit Abschirmungsmaterial **(23)** über weiteres Dielektrikum **(25)** mit einer ersten Lage Leiter **(10,12,12')** verbunden wird und dass ein weiteres Folienhalbzeug **(H3)** mit Abschirmungsmaterial **(33)** über weiteres Dielektrikum **(35)** mit weiteren Lage Leiter **(10',13,13')** verbunden wird.

4. Verfahren gemäss Anspruch 1, **dadurch gekennzeichnet**, dass das erste Folienhalbzeug **(H1)** mit zwei Lagen Leiter **(10,10',12,12', 13,13')** getrennt durch ein erstes Dielektrikum **(15)** verwendet wird, wobei Signalleiter **(10,10')** aus beiden Lagen über Signalleiterdurchplattierungen **(100)** und wobei Abschirmungsleiter **(12,12',13,13')** aus beiden Lagen über Abschirmungsleiterdurchplattierungen **(123,123')** elektrisch durchkontaktiert sind.

5. Verfahren gemäss einem der Ansprüche 1 bis 4, **dadurch gekennzeichnet**, dass das erste Folienhalbzeug (**H1**) mit mindestens einer Lage Leiter **(10,10',12,12',13,13')** verwendet wird, wobei Signalleiter **(10,10')** einer Lage jeweils beabstandet zu zwei nächstliegenden Abschirmungsleitem **(12,12',13,13')** derselben Lage verlaufen und dass Abschirmungsmaterial **(23,33)** mit diesen zwei nächstliegenden Abschirmungsleitem **(12,12',13,13')** eines Signalleiters **(10,10')** elektrisch kontaktiert wird.

6. Verfahren gemäss Anspruch 5, **dadurch gekennzeichnet**, dass das erste Folienhalbzeug (**H1**) mit einer ersten Lage Signalleiter **(10)** sowie Abschirmungsleiter (**12,13**) und mit einer weiteren Lage Abschirmungsleiter (**12',13'**) verwendet wird, wobei diese Signalleiter **(10)** zu jeweils zwei nächstliegenden Abschirmungsleitern (**12,13**) derselben Lage beabstandet verlaufen und wobei diese Signalleiter **(10)** zu mindestens einem nächstliegenden Abschirmungsleiter **(12',13')** dieser weiteren Lage beabstandet verlaufen, dass Abschirmungsmaterial **(23)** mit diesen nächstliegenden Abschirmungsleitem **(12,12',13,13')** eines Signalleiters **(10)** elektrisch kontaktiert wird.

7. Verfahren gemäss einem der Ansprüche 1 bis 6, **dadurch gekennzeichnet**, dass Dielektrikumsöffnungen **(220,220',320,320')** chemisch geätzt oder Plasma geätzt werden.

8. Verfahren gemäss einem der Ansprüche 1 bis 6, **dadurch gekennzeichnet**, dass Dielektrikumsöffnungen **(220,220',320,320')** durch Laser-Ablation abgetragen werden.

9. Verfahren gemäss einem der Ansprüche 1 bis 8, **dadurch gekennzeichnet**, dass Ränder dieser Öffnungen **(22,22',32,32')** im Abschirmungsmaterial **(23,33)** durch Aufplattierung von leitfähigem Material elektrisch mit Abschirmungsleitem **(12,12',13,13')** kontaktiert werden.

10. Verfahren gemäss einem der Ansprüche 1 bis 8, **dadurch gekennzeichnet**, dass Ränder dieser Öffnungen **(22,22',32,32')** im Abschirmungsmaterial **(23,33)** durch Einbringen von leitfähigen Polymeren mit Abschirmungsleitem **(12,12',13,13')** elektrisch kontaktiert werden.

11. Verfahren gemäss einem der Ansprüche 1 bis 8, **dadurch gekennzeichnet**, dass Ränder dieser Öffnungen **(22,22',32,32')** im Abschirmungsmaterial **(23,33)** in Dielektrikumsöffnungen **(220,220',320,320')** umgebogen werden.

12. Verfahren gemäss einem der Ansprüche 1 bis 8, **dadurch gekennzeichnet**, dass Ränder dieser Öffnungen **(22,22',32,32')** im Abschirmungsmaterial **(23,33)** selektiv abgeätzt werden.

## Claims

1. Method for the manufacture of shielded interconnecting conductors (1) from semifinished foil products (H1, H2, H3),
**wherein**
a first semifinished foil product (H1) with at least one layer of conductors (10, 10', 12, 12', 13, 13') is used which conductors consist of conductors (10, 10') and shielding conductors (12, 12', 13, 13'),
at least one further semifinished foil product (H2, H3) with shielding material (23, 33) is used
the shielding material (23, 33) is joined via dielectric (15, 25, 35) to at least one layer of conductors (10, 10', 12, 12', 13, 13'),
the shielding material (23, 33) is provided with openings (22, 22', 32, 32') extending to the dielectric (15, 25, 35) in a photochemical structuring in the vicinity of the shielding conductors (12, 12', 13, 13'),
the dielectric (15, 25, 35) is removed until extending to the shielding conductors (12, 12', 13, 13') in accordance with the openings (22, 22', 32, 32') in the shielding material (23, 33)
the shielding material (23, 33) is electrically contacted with shielding conductors (12, 12', 13, 13') via openings (22, 22', 32, 32') in the shielding material (23, 33) so that signal conductors (10, 101) are insulated by dielectric (15, 25, 35) and shielded by shielding conductors (12, 121, 13, 131) electrically connected to shielding material (23, 33).

2. Method according to claim 1, **characterized** in that a first semifinished foil product (H1) with two layers of conductors (10, 101, 12, 12', 13, 131), separated by a first dielectric (15) is used, the signal conductors (10, 10') from both layers being electrically plated through via signal conductor plated-through holes (100) and shielding conductors (12, 12', 13, 13') from both layers are electrically plated-through via shielding conductor plated-through holes (123, 123').

3. Method according to claim 1, **characterized** in that a first semifinished foil product (H1) with the layer of conductors (10, 12, 12') on a first dielectric (15) is used, that a further semifinished foil product (H2) with shielding material (23) is joint via further dielectric (25) to the layer of conductors (10, 12, 12') and that a further semifinished foil product (H3) with shielding material (33) is joint via further dielectric (35) to a further layer of conductors (10', 13, 13').

4. Method according to claim 1, **characterized** in that a first semifinished foil product (H1) with two layers of conductors (10, 10', 12, 12', 13, 13') separated by a first dielectric (15) is used, signal conductors (10, 10') from both layers being electrically plated through via signal conductor-plated through holes (100) and shielding conductors (12, 12', 13, 13') from both layers are electrically plated-through via shielding conductor plated-through holes.

5. Method according to one of the claims 1 to 4, **characterized** in that the first semifinished foil product (H1) with at least one layer of conductors (10, 10', 12, 12', 13, 13') is used, signal conductors (10, 10') of one layer being in each case spaced from the two closest shielding conductors (12, 12', 13, 13') of the same layer and that shielding material (23, 33) is electrically contacted with said two closest shielding conductors (12, 12', 13, 13') of a signal conductor (10, 10').

6. Method according to claim 5, **characterized** in that a first semifinished foil product (H1) with a first layer of signal conductors (10) and shielding conductors (12, 13) and with a further layer of shielding conductors (12', 13') is used, said signal conductors (10) being spaced with respect to the two closest shielding conductors (12, 13) of the same layer and in which said signal conductors (10) are spaced with respect to at least one closest shielding conductor (12', 13') of said further layer and that the shielding material (23) is electrically contacted with the closest shielding conductors (12, 12', 13, 13') of a signal conductor (10).

7. Method according to one of the claims 1 to 6, **characterized** in that dielectric openings (220, 220', 320, 320') are chemically or plasma etched.

8. Method according to one of the claims 1 to 6, characterized in that the dielectric openings (220, 220', 320, 320') are removed by laser ablation.

9. Method according to one of the claims 1 to 8, **characterized** in that the edges (24, 24', 34, 34') of said openings (22, 22', 32, 32') in the shielding material (23, 33) are electrically contacted with the shielding conductors (12, 12', 13, 13') by plating on conductive material.

10. Method according to one of the claims 1 to 8, **characterized** in that the edges (24, 24', 34, 34') of these openings (22, 22', 32, 32') in the shielding material (23, 33) are electrically contacted with shielding conductors (12, 12', 13, 13') by introducing conductive polymers.

11. Method according to one of the claims 1 to 8, **characterized** in that edges (24, 24', 34, 34') of said openings (22, 22', 32, 32') in the shielding material (23, 33) are bent round in dielectric openings (220, 220', 320, 320').

12. Method according to one of the claims 1 to 8, **characterized** in that the edges (24, 24', 34, 34') of these openings (22, 22', 32, 32') in the shielding material (23, 33) are selectively etched away.

## Revendications

1. Procédé de fabrication de conducteurs de liaison blindés (1) à partir de feuilles semi-finies (H1, H2, H3),
dans lequel
on utilise une première feuille semi-finie (H1) dotée d'au moins une couche de conducteurs (10, 10', 12, 12', 13, 13'), lesquels conducteurs (10, 10', 12, 12', 13, 13') sont constitués de conducteurs de signaux (10, 10') et de conducteurs de blindage (12, 12', 13, 13'),
on utilise au moins une autre feuille semi-finie (H2, H3) dotée d'un matériau de blindage (23, 33),
le matériau de blindage (23, 33) est relié par l'intermédiaire d'un diélectrique (15, 25, 35) à la couche de conducteurs (10, 10', 12, 12', 13, 13') au moins présente,
le matériau de blindage (23, 33) est doté d'une structuration photochimique dans la région des conducteurs de blindage (12, 12', 13, 13'), avec des ouvertures (22, 22', 32, 32') débouchant sur le diélectrique (15, 25, 35),
au niveau des ouvertures (22, 22', 32, 32') ménagées dans le matériau de blindage (23, 33), le diélectrique (15, 25, 35) est enlevé jusqu'aux conducteurs de blindage (12, 12', 13, 13'), et
le matériau de blindage (23, 33) est mis en contact électrique avec les conducteurs de blindage (12, 12', 13, 13') par l'intermédiaire des ouvertures (22, 22', 32, 32') ménagées dans le matériau de blindage (23, 33), de telle sorte que les conducteurs de signaux (10, 10') isolés par le diélectrique (15, 25, 35) soient blindés et par les conducteurs de blindage (12, 12', 13, 13') et par le matériau de blindage (23, 33) qui est relié électriquement à ces derniers.

2. Procédé selon la revendication 1, caractérisé en ce que la première feuille semi-finie (H1) dotée de la couche de conducteurs (10, 12, 12') est utilisée sur un premier diélectrique (15), en ce qu'une autre feuille semi-finie (H2) dotée du matériau de blindage (23) est reliée à la couche de conducteurs (10, 12, 12') par l'intermédiaire d'un autre diélectrique (25) et en ce qu'une autre feuille semi-finie (H3) dotée d'un matériau de blindage (33) est reliée au premier diélectrique (15) par l'intermédiaire d'un autre diélectrique (35).

3. Procédé selon la revendication 1, caractérisé en ce que la première feuille semi-finie (H1) dotée de deux couches de conducteurs (10, 10', 12, 12', 13, 13') est utilisée sur un premier diélectrique (15), en ce qu'une autre feuille semi-finie (H2) dotée d'un matériau de blindage (23) est reliée à une première couche de conducteurs (10, 12, 12') par l'intermédiaire d'un autre diélectrique (25) et en ce qu'une autre feuille semi-finie (H3) dotée d'un matériau de blindage (33) est reliée à une autre couche de conducteurs (10', 13, 13') par l'intermédiaire d'un autre diélectrique (35).

4. Procédé selon la revendication 1, caractérisé en ce que l'on utilise la première feuille semi-finie (H1) dotée de deux couches de conducteurs (10, 10', 12, 12', 13, 13') séparées par un premier diélectrique (15), des conducteurs de signaux (10, 10') des deux couches sont mis en contact électrique mutuel par des placages (100) de conducteurs de signaux, et des conducteurs de blindage (12, 12', 13, 13') des deux couches sont mis en contact électrique mutuel par l'intermédiaire de placages (123, 123') de conducteurs de blindage.

5. Procédé selon l'une des revendications 1 à 4, caractérisé en ce que l'on utilise la première feuille semi-finie (H1) dotée d'au moins une couche de conducteurs (10, 10', 12, 12', 13, 13'), les conducteurs de signaux (10, 10') d'une couche s'étendant chaque fois à distance par rapport à deux conducteurs de blindage (12, 12', 13, 13'), immédiatement voisins, de la même couche, et en ce que le matériau de blindage (23, 33) est mis en contact électrique avec ces deux conducteurs de blindage (12, 12', 13, 13'), immédiatement voisins, d'un conducteur de signaux (10, 10').

6. Procédé selon la revendication 5, caractérisé en ce que l'on utilise la première feuille semi-finie (H1) dotée d'une première couche de conducteurs de signaux (10) et de conducteurs de blindage (12, 13) ainsi que d'une autre couche de conducteurs de blindage (12', 13'), ces conducteurs de signaux (10) s'étendant à distance chaque fois de deux conducteurs de blindage (12, 13), immédiatement voisins, de la même couche, ces conducteurs de signaux (10) s'étendant à distance d'au moins un conducteur de blindage (12', 13'), immédiatement voisin, de cette autre couche, et en ce qu'un matériau de blindage (23) est mis en contact électrique avec ces conducteurs de blindage (12, 12', 13, 13'), immédiatement voisins, d'un conducteur de signaux (10).

7. Procédé selon l'une des revendications 1 à 6, caractérisé en ce que des ouvertures (220, 220', 320, 320') ménagées dans le diélectrique sont gravées chimiquement ou sont gravées par plasma.

8. Procédé selon l'une des revendications 1 à 6, caractérisé en ce que des ouvertures (220, 220', 320, 320') sont ménagées dans le diélectrique par ablation au laser.

9. Procédé selon l'une des revendications 1 à 8, caractérisé en ce que des bords (24, 24', 34, 34') de ces ouvertures (22, 22', 32, 32') ménagées dans le matériau de blindage (23, 33) sont mis en contact électrique avec les conducteurs de blindage (12, 12', 13, 13') par placage d'un matériau conducteur.

10. Procédé selon l'une revendications 1 à 8, caractérisé en ce que des bords (24, 24', 34, 34') de ces ouvertures (22, 22', 32, 32') ménagées dans le matériau de blindage (23, 33) sont mis en contact électrique avec des conducteurs de blindage (12, 12', 13, 13') par apport d'un polymère conducteur.

11. Procédé selon l'une des revendications 1 à 8, caractérisé en ce que des bords (24, 24', 34, 34') de ces ouvertures (22, 22', 32, 32') ménagées dans le matériau de blindage (23, 33) sont rabattus dans les ouvertures (220, 220', 320, 320') ménagées dans le diélectrique.

12. Procédé sur l'une des revendications 1 à 8, caractérisé en ce que des bords (24, 24', 34, 34') de ces ouvertures (22, 22', 32, 32') sont gravés de manière sélective dans le matériau de blindage (23, 33).
